(19) Europäisches Patentamt / European Patent Office / Office européen des brevets

(11) **EP 4 633 316 A1**

(12) **EUROPEAN PATENT APPLICATION**

(43) Date of publication:
**15.10.2025 Bulletin 2025/42**

(21) Application number: **25168252.2**

(22) Date of filing: **03.04.2025**

(51) International Patent Classification (IPC):
**H05K 9/00** *(2006.01)*    **B32B 25/02** *(2006.01)*
**C08K 3/04** *(2006.01)*    **C08K 7/06** *(2006.01)*

(52) Cooperative Patent Classification (CPC):
(C-Sets available)
**B32B 25/02; H05K 9/0083; H05K 9/0088;**
B32B 2262/106; C08K 3/041; C08K 7/06    (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **11.04.2024 JP 2024064020**

(71) Applicant: SHIN-ETSU CHEMICAL CO., LTD.
**Tokyo 1000005 (JP)**

(72) Inventors:
- **NISHIMURA, Tsubasa**
  **Annaka-shi, 3790224 (JP)**
- **OSAKI, Akihiko**
  **Annaka-shi, 3790224 (JP)**

(74) Representative: **Ter Meer Steinmeister & Partner
Patentanwälte mbB
Nymphenburger Straße 4
80335 München (DE)**

(54) **ELECTROMAGNETIC WAVE SHIELDING MEMBER**

(57) An electromagnetic wave shielding member having an electromagnetic wave absorbing layer containing an electromagnetic wave absorbing filler and a binder resin, and a reflection layer disposed on an opposite surface side of an electromagnetic wave incident surface of the electromagnetic wave absorbing layer, wherein the electromagnetic wave absorbing layer has a dielectric constant of 4 to 30 and a dielectric loss tangent of 0.1 to 2.0, the content of the electromagnetic wave absorbing filler is 1 to 20 wt% based on the total weight of the electromagnetic wave absorbing layer, and the reflection layer has a volume resistivity of $1 \times 10^{-4}$ to $1 \times 10^{-1}$ $\Omega \cdot cm$.

**FIG.1**

VERTICALLY INCIDENT ELECTROMAGNETIC WAVE

EP 4 633 316 A1

(52)  Cooperative Patent Classification (CPC): (Cont.)

C-Sets
**C08K 3/04, C08L 83/04**

**Description**

TECHNICAL FIELD

The present invention relates to an electromagnetic wave shielding member suitably used for high-speed, large-capacity communication equipment and semiconductor devices used for vehicles.

BACKGROUND ART

High-speed and large-capacity communication using radio waves in a so-called millimeter wave band with a frequency of 30 to 300 GHz is expected to be utilized in various fields such as 5G-compatible communication devices, automobile automatic driving systems, and remote medical systems. Among them, the electromagnetic wave absorbing material is known as a member that absorbs unnecessary leakage and reflection of radio waves, and plays a role of maintaining a stable communication environment and preventing malfunction.

In the field of development of electromagnetic wave absorbing materials for millimeter wave, there have been many reports on development of a $\lambda/4$ type electromagnetic wave absorbing sheet in which a dielectric layer filled with a carbon-based filler in a resin and a reflection layer made of a conductive material are attached to the dielectric layer. However, in these electromagnetic wave absorbing sheets, only narrowband absorption characteristics are obtained for reasons of absorption principles, and performance is limited to an absorption band of about 10 GHz for an attenuation of 10 dB and an absorption band of about 5 GHz for an attenuation of 20 dB (Patent Documents 1 and 2).

On the other hand, in order to obtain wide band absorption characteristics, one designed with two or more dielectric layers has been reported (Patent Document 3). However, since the electromagnetic wave absorber having such a multilayer structure requires many parameter controls such as dielectric characteristics, film thicknesses, and a lamination method of each layer, there remains a problem that the barrier to practical use is high and the manufacturing cost is greatly increased.

Therefore, in consideration of practicability and convenience, it is considered that an electromagnetic wave absorbing material for millimeter wave having high absorption performance with an attenuation of 10 dB or more and a wide absorption band of 20 GHz or more is more effective, but a report clearly describing the performance as described above has not been made so far in a $\lambda/4$ type electromagnetic wave absorbing material.

Citation List

Patent Document 1: WO 2018/168859
Patent Document 2: JP-A 2023-129145
Patent Document 3: JP-A 2020-145278

SUMMARY OF THE INVENTION

The present invention has been made to solve the above problems, and an object thereof is to provide an electromagnetic wave shielding member exhibiting a wide absorption band and excellent absorption characteristics and shielding characteristics in a high frequency band of 60 to 90 GHz.

As a result of intensive studies to achieve the above object, the present inventors have found that an electromagnetic wave shielding member including an electromagnetic wave absorbing filler and a binder resin, an electromagnetic wave absorbing layer having a dielectric constant of 4 to 30 and a dielectric loss tangent of 0.1 to 2.0, and a reflection layer disposed on an opposite surface side of an electromagnetic wave incident surface of the electromagnetic wave absorbing layer, having a volume resistivity of $1\times10^{-4}$ to $1\times10^{-1}$ $\Omega\cdot$cm, wherein the content of the electromagnetic wave absorbing filler is 1 to 20 wt% based on the total weight of the electromagnetic wave absorbing layer, exhibits a wide absorption band and excellent absorption characteristics and shielding characteristics in a high frequency band of 60 to 90 GHz, and have completed the present invention.

Therefore, the present invention provides the following electromagnetic wave shielding member.

1. An electromagnetic wave shielding member including an electromagnetic wave absorbing layer containing an electromagnetic wave absorbing filler and a binder resin, and a reflection layer disposed on an opposite surface side of an electromagnetic wave incident surface of the electromagnetic wave absorbing layer, wherein the electromagnetic wave absorbing layer has a dielectric constant of 4 to 30 and a dielectric loss tangent of 0.1 to 2.0, the content of the electromagnetic wave absorbing filler is 1 to 20 wt% based on the total weight of the electromagnetic wave absorbing layer, and the reflection layer has a volume resistivity of $1\times10^{-4}$ to $1\times10^{-1}$ $\Omega\cdot$cm.

2. The electromagnetic wave shielding member according to 1 above, wherein the electromagnetic wave absorbing filler is one or more selected from the group consisting of carbon black, carbon nanotubes, and carbon fibers.

3. The electromagnetic wave shielding member according to 1 or 2 above, wherein the binder resin has a dielectric constant of 5 or less.

4. The electromagnetic wave shielding member according to 1 or 2 above, wherein the reflection layer is made of a carbon material.

5. The electromagnetic wave shielding member according to 4 above, wherein the carbon material is one or more selected from the group consisting of carbon nanotubes, carbon fibers, graphite, and graphene.

6. The electromagnetic wave shielding member according to 1 or 2 above, which has a transmission attenuation of 30 dB or more in an entire frequency band of 60 to 90 GHz.

7. The electromagnetic wave shielding member according to 1 or 2 above, wherein the frequency bandwidth with a reflection attenuation of 10 dB or more is 20 GHz or more in a frequency band of 60 to 90 GHz.

8. The electromagnetic wave shielding member according to 1 or 2 above, which has a reflection attenuation of 20 dB or more in at least a part of a frequency band of 60 to 90 GHz.

## ADVANTAGEOUS EFFECTS OF THE INVENTION

According to the electromagnetic wave shielding member of the present invention, it is possible to exhibit a wide absorption region and excellent absorption characteristics and shielding characteristics in a high frequency band of 60 to 90 GHz. Since the electromagnetic wave shielding member can be made thinner than the conventional electromagnetic wave shielding member, the electromagnetic wave shielding member can be installed even in a narrow space in the device, and is extremely useful as the electromagnetic wave shielding member.

## BRIEF DESCRIPTION OF THE DRAWINGS

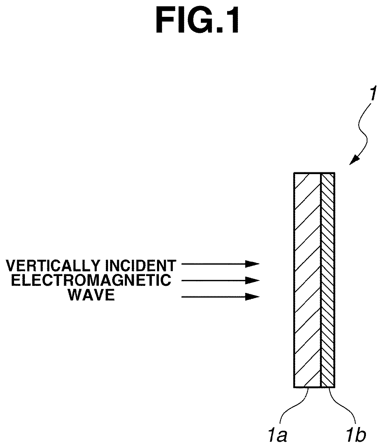

FIG. 1 is a schematic cross-sectional view of an electromagnetic wave shielding member (electromagnetic wave shielding sheet) of the present invention.

## DESCRIPTION OF THE PREFERRED EMBODIMENT

Hereinafter, the present invention is described in detail, but the present invention is not limited thereto.

The electromagnetic wave shielding member of the present invention includes an electromagnetic wave absorbing layer containing an electromagnetic wave absorbing filler and a binder resin, and a reflection layer.

The content of the electromagnetic wave absorbing filler is 1 to 20 wt%, preferably 1 to 10 wt% based on the total weight of the electromagnetic wave absorbing layer. Also, the reflection layer has a volume resistivity of $1\times10^{-4}$ to $1\times10^{-1}$ $\Omega\cdot$cm, preferably $1\times10^{-3}$ to $1\times10^{-1}$ $\Omega\cdot$cm.

In the present invention, the volume resistivity is a value measured by a four-point probe method described in JIS K7194:1994.

The method for bonding the electromagnetic wave absorbing layer and the reflection layer is not particularly limited, and an adhesive agent or the like may be used as an adhesive layer between the electromagnetic wave absorbing layer and the reflection layer. Alternatively, a simple lamination method by pressure bonding or the like can also be used without chemical adhesion such as an adhesive agent.

Further, in the electromagnetic wave shielding member of the present invention, a functional film can be installed on the outer peripheral surface of the electromagnetic wave shielding member for the purpose of imparting insulating properties or adhesiveness, physical protection, or the like.

Hereinafter, each layer is described in detail.

<Electromagnetic wave absorbing layer>

The electromagnetic wave absorbing layer of the present invention contains an electromagnetic wave absorbing filler and a binder resin. The electromagnetic wave absorbing layer is used for the purpose of converting an incident electromagnetic wave into heat to absorb the electromagnetic wave, and for the purpose of controlling the frequency of the electromagnetic wave incident on the electromagnetic wave absorbing layer.

The electromagnetic wave absorbing layer has a dielectric constant of 4 to 30, preferably 4 to 15. When the electromagnetic wave absorbing layer has a dielectric constant of 30 or less, the reflection component from the surface of the electromagnetic wave absorbing layer is small and the transmission component is large, so that the absorption efficiency of the electromagnetic wave absorbing layer is increased, which is preferable.

The dielectric loss tangent of the electromagnetic wave absorbing layer is a coefficient of absorbing an electromagnetic wave to convert the electromagnetic wave into heat, thus needs to be 0.1 to 2.0, and is preferably 0.3 to 1.6. Also, the dielectric loss tangent is preferably in a range of ±20% around a value satisfying the following formula (1). When the dielectric loss tangent and the dielectric constant satisfy the following formula (1), matching conditions of a reflected wave of the electromagnetic wave from the dielectric layer and a reflected wave of the electromagnetic wave from the reflection layer can be matched.

$$\tan \delta = 1.27 \, \varepsilon_r^{-0.5} \qquad (1)$$

wherein $\tan\delta$ is a dielectric loss tangent of the electromagnetic wave absorbing layer, and $\varepsilon_r$ is a dielectric constant of the electromagnetic wave absorbing layer.

In the present invention, the dielectric constant and the dielectric loss tangent were measured by a free space method.

The thickness of the electromagnetic wave absorbing layer in the present invention is not particularly limited, but is preferably in a range of ±20% around a value satisfying the following formula (2). When the thickness of the electromagnetic wave absorbing layer has a value satisfying the following formula (2), matching conditions of a reflected wave of the electromagnetic wave from the dielectric layer and a reflected wave of the electromagnetic wave from the reflection layer can be matched in an arbitrary frequency band, and an attenuation of 20 dB or more can be theoretically obtained.

$$d = 0.25 \, cf^{-1}\varepsilon_r^{-0.5} + 0.5 \, Ncf^{-1}\varepsilon_r^{-0.5} \qquad (2)$$

wherein d is a film thickness (m) of the electromagnetic wave absorbing layer, c is a light flux (m/s), f is a frequency (Hz), $\varepsilon_r$ is a dielectric constant of the electromagnetic wave absorbing layer, and N is an integer of 0 or more.

The method for producing a composition constituting the electromagnetic wave absorbing layer in the present invention is not particularly limited, but mixing can be carried out by a known kneader. Examples of the kneader include a kneader, a Banbury mixer, a two-roll, a three-roll, a planetary mixer, a gate mixer, a rotation-revolution mixer, and the like, and a three-roll and a planetary mixer, which are easy to operate and can be uniformly mixed, are preferred. In addition, at the time of mixing, the binder resin, the electromagnetic wave absorbing filler, and optional components may be simultaneously kneaded, or may be kneaded while being added one by one. As a method for molding the obtained composition, for example, a known method such as vacuum molding, press forming, or injection molding can be used.

(Binder resin)

The binder resin used in the electromagnetic wave absorbing layer is used as a binder of the electromagnetic wave absorbing filler. The binder resin is not particularly limited, and examples thereof include a polycarbonate resin, a polyethylene resin, a polypropylene resin, a polystyrene resin, a polyimide resin, a thermosetting polyimide resin, a polyethylene terephthalate resin, a polyamide resin, a polyester resin, a polyvinyl chloride resin, a polyurethane resin, a maleimide resin, a polyether ketone resin, a silicone resin, a phenol resin, an epoxy resin, and an unsaturated polyester resin. These resins may be used singly or in admixture of two or more kinds thereof. Among them, a resin having a dielectric constant of 5 or less is preferred, and examples thereof include a silicone resin, a maleimide resin, a bismaleimide resin, and a polyether ketone resin. When the resin has a dielectric constant of 5 or less, the reflection component from the surface of the electromagnetic wave absorbing layer is small and the transmission component is large, so that the absorption efficiency of the electromagnetic wave absorbing layer is increased, which is preferable.

(Electromagnetic wave absorbing filler)

The electromagnetic wave absorbing filler used for the electromagnetic wave absorbing layer is used for the purpose of controlling the dielectric constant of the electromagnetic wave absorbing layer and for the purpose of absorbing the electromagnetic wave to convert the electromagnetic wave into heat. The electromagnetic wave absorbing filler is not particularly limited, but can be used singly or in combination of two or more kinds thereof. Examples of the electromagnetic wave absorbing filler include graphite, carbon fiber, graphene, graphene oxide, graphite, carbon nanotube, fullerene, silicon carbide, iron oxide, nano-iron oxide, and ferrite. Among them, carbon black, carbon nanotube, carbon fiber, and silicon carbide having good absorption performance in a high frequency range are preferred. Examples of the type of carbon black include furnace black, channel black, acetylene black, and thermal black. Examples of the type of carbon nanotube include single-walled carbon nanotube and multi-walled carbon nanotube. Examples of the type of carbon fiber include PAN-based carbon fiber and pitch-based carbon fiber. The amount of the electromagnetic wave absorbing filler added is 1 to 20 wt%, preferably 1 to 10 wt% based on the total weight of the electromagnetic wave absorbing layer.

(Optional components)

In the electromagnetic wave absorbing layer, in addition to the above components, optional components can be appropriately blended as long as the object and effect of the present invention are not impaired. For example, various optional components may be added for the purpose of appropriately adjusting the shrinkage rate at the time of curing, and the thermal expansion coefficient, mechanical strength, heat resistance, chemical resistance, flame retardancy, gas permeability, thermal conductivity, oxidation resistance, and the like of the cured product to be obtained. Examples of such an optional component include inorganic fillers such as silica, fumed silica, quartz powder, glass fiber, titanium dioxide, calcium carbonate, magnesium carbonate, aluminum hydroxide, alumina (aluminum oxide), aluminum nitride, magnesium oxide, and boron nitride, and antioxidants such as hydroquinone and 2,6-tert-butyl-p-cresol.

<Reflection layer>

The reflection layer is used for the purpose of converting the electromagnetic wave transmitted from the electromagnetic wave absorbing layer into heat, and for the purpose of preventing unnecessary leakage of the electromagnetic wave to a semiconductor device on the back surface as a shielding material. The reflection layer of the electromagnetic wave shielding member according to the present embodiment is a member disposed on the side opposite to the electromagnetic wave incident surface of the electromagnetic wave absorbing layer.

The film thickness of the reflection layer is not particularly limited as long as the reflection layer has a transmission attenuation of 30 dB or more. In the case of an excessively thin film, the transmission attenuation may decrease, and the electromagnetic wave incident on the reflection layer may be transmitted.

The reflection layer has a volume resistivity of $1\times10^{-4}$ to $1\times10^{-1}$ $\Omega\cdot$cm, preferably $1\times10^{-3}$ to $1\times10^{-1}$ $\Omega\cdot$cm. When the volume resistivity is less than $1\times10^{-4}$ $\Omega\cdot$cm, the conversion efficiency of the electromagnetic wave transmitted from the electromagnetic wave absorbing layer into heat may decrease. Also, when the volume resistivity exceeds $1\times10^{-1}$ $\Omega\cdot$cm, a sufficient shielding effect may not be obtained. The constituent material of the reflection layer is not particularly limited as long as it is within the range of the volume resistivity, and examples thereof include carbon materials such as carbon fibers, carbon nanotubes, graphene, and graphite, and metal powders such as silver, copper, and aluminum. Among them, carbon materials are preferred. In the case of the reflection layer made of such a material, the conversion efficiency of the electromagnetic wave transmitted from the electromagnetic wave absorbing layer into heat is high, so that compatibility between high absorbency and wide band absorbency is further improved.

[Frequency characteristics of electromagnetic wave absorbing material]

The transmission attenuation is preferably 30 dB or more in an entire frequency band of 60 to 90 GHz. When the transmission attenuation amount is 30 dB or more, the electromagnetic wave incident on the electromagnetic wave absorbing layer can be sufficiently reflected without being transmitted through the reflection layer. Also, in at least a part of the frequency range of 60 to 90 GHz, the reflection attenuation is preferably 20 dB or more, and the frequency range with a reflection attenuation of 10 dB or more is preferably 20 GHz or more. When the frequency range of the electromagnetic wave attenuation of 10 dB or more is 20 GHz or more, it is possible to flexibly cope with electromagnetic wave devices having different frequencies, and furthermore, a material having an attenuation of 20 dB or more is a more excellent electromagnetic wave shielding member.

EXAMPLES

Hereinafter, the present invention is described specifically with reference to Examples and Comparative Examples, but the present invention is not limited to the following Examples.

<Preparation of electromagnetic wave shielding sheet>

A binder resin, an electromagnetic wave absorbing filler and optional components were blended so as to have contents as shown in Tables 1 and 2 based on the total weight of the electromagnetic wave absorbing layer, and mixed for 1 hour using a planetary mixer to obtain an electromagnetic wave absorbing material composition. The obtained electromagnetic wave absorbing material composition was molded into a sheet of 120 mm × 120 mm square with the thickness of the electromagnetic wave absorbing layer shown in Tables 1 and 2 by press molding, and then heated and cured at 150°C for 2 hours to obtain a sheet-like electromagnetic wave absorbing layer. The obtained electromagnetic wave absorbing layer and reflection layer were bonded to each other, and pressure-bonded under the conditions of 1 MPa and 10 minutes to prepare an electromagnetic wave shielding sheet (electromagnetic wave shielding member). FIG. 1 shows an electromagnetic wave shielding sheet 1 including an electromagnetic wave absorbing layer 1a and a reflection layer 1b.

Materials used for the electromagnetic wave shielding sheet of each example are as follows.

- Silicone resin: KE-106 (manufactured by Shin-Etsu Chemical Co., Ltd.)

- Bismaleimide resin: SLK-3000 (manufactured by Shin-Etsu Chemical Co., Ltd.)

- Carbon black: Ketjen black (manufactured by Lion Specialty Chemicals Co., Ltd.)

- Carbon fiber: ZY-300-25M (manufactured by Nippon Graphite Fiber Co., Ltd.)

- Alumina: AC-5500SI (manufactured by ADMATECHS COMPANY LIMITED)

- Carbon nanotube sheet (CNT sheet): S-T01AVB-12 (manufactured by Huntsman Corporation)

- Carbon fiber sheet: ASA-60S-A4, manufactured by SAKAI OVEX CO., LTD.

- Graphite sheet: WW-T68A-140140, manufactured by WIDE WORK CORPORATION

<Measurement of dielectric characteristics and electromagnetic wave shielding characteristics>

The dielectric constant, the dielectric loss tangent, and the electromagnetic wave shielding characteristics were measured by a free space method using the above-described electromagnetic wave shielding sheet as a measurement object. Specifically, using a network analyzer (manufactured by KEYCOM Corporation), a horn antenna (manufactured by KEYCOM Corporation), and a dielectric lens (manufactured by KEYCOM Corporation), as shown in FIG. 1, the electromagnetic wave shielding sheet 1 was irradiated with a vertically incident electromagnetic wave from the opposite surface side of the reflection layer 1b, and measurement was performed from the incident wave and the reflected wave at that time.

| | |
|---|---|
| Minimum reflection attenuation: | minimum value of reflection attenuation in 60 to 90 GHz frequency band |
| Maximum reflection attenuation: | maximum value of reflection attenuation in 60 to 90 GHz frequency band |
| Minimum transmission attenuation: | minimum value of transmission attenuation in 60 to 90 GHz frequency band |
| Maximum transmission attenuation: | maximum value of transmission attenuation in 60 to 90 GHz frequency band |

Reflection attenuation region width of 10 dB or more:
a frequency range indicating an attenuation of 10 dB or more in a frequency band of 60 to 90 GHz

Table 1

| | | Example | | | | | | | |
|---|---|---|---|---|---|---|---|---|---|
| | | 1 | 2 | 3 | 4 | 5 | 6 | 7 | 8 |
| Resin layer | Type | Silicone | Silicone | Silicone | Silicone | Silicone | Silicone | Silicone | Bismaleimide |
| Electromagnetic wave absorbing filler | Type | Carbon black | Carbon black | Carbon black | Carbon black | Carbon fiber | Carbon black | Carbon black | Carbon black |
| | Added amount (wt%) | 4.7 | 2.6 | 5.0 | 2.6 | 1.5 | 2.6 | 2.6 | 2.7 |
| Optional component | Type | None | Alumina | Alumina | Alumina | Alumina | Alumina | Alumina | Alumina |
| | Added amount (wt%) | - | 60 | 30 | 60 | 80 | 60 | 60 | 80 |
| Electromagnetic wave absorbing layer | Thickness (mm) | 0.44 | 0.38 | 0.34 | 0.65 | 0.26 | 0.38 | 0.38 | 0.28 |
| | Dielectric constant | 5.6 | 8.4 | 8.5 | 8.4 | 22 | 8.4 | 8.4 | 12.4 |
| | Dielectric loss tangent | 0.54 | 0.43 | 0.62 | 0.43 | 0.27 | 0.43 | 0.43 | 0.36 |
| Reflection layer | Type | CNT sheet | CNT sheet | CNT sheet | CNT sheet | CNT sheet | Carbon fiber sheet | Graphite sheet | CNT sheet |
| | Thickness (mm) | 0.020 | 0.020 | 0.020 | 0.020 | 0.020 | 0.100 | 0.025 | 0.020 |
| | Volume resistivity ($\Omega \cdot$cm) | $2 \times 10^{-3}$ | $2 \times 10^{-3}$ | $2 \times 10^{-3}$ | $2 \times 10^{-3}$ | $2 \times 10^{-3}$ | $3 \times 10^{-3}$ | $3 \times 10^{-2}$ | $2 \times 10^{-3}$ |
| Minimum reflection attenuation [60 to 90 GHz] (dB) | | 14 | 17 | 8 | 12 | 9 | 16 | 15 | 19 |
| Maximum reflection attenuation [60 to 90 GHz] (dB) | | 35 | 37 | 18 | 19 | 35 | 26 | 28 | 37 |
| Minimum transmission attenuation [60 to 90 GHz] (dB) | | 53 | 53 | 55 | 55 | 54 | 47 | 45 | 54 |
| Maximum transmission attenuation [60 to 90 GHz] (dB) | | 60 | 61 | 63 | 65 | 62 | 56 | 51 | 60 |
| Reflection attenuation region width of 10 dB or more (GHz) | | 30 or more | 30 or more | 22 | 30 or more | 25 | 30 or more | 30 or more | 30 or more |

EP 4 633 316 A1

8

Table 2

| | | Comparative Example | | | | |
|---|---|---|---|---|---|---|
| | | 1 | 2 | 3 | 4 | 5 |
| Resin layer | Type | Silicone | None | Silicone | Silicone | Silicone |
| Electromagnetic wave absorbing filler | Type | None | None | Carbon black | Carbon black | Carbon fiber |
| | Added amount (wt%) | - | - | 2.6 | 2.6 | 3.0 |
| Optional component | Type | - | None | Alumina | Alumina | Alumina |
| | Added amount (wt%) | - | - | 60 | 60 | 80 |
| Electromagnetic wave absorbing layer | Thickness (mm) | 0.58 | - | 0.38 | 0.38 | 0.40 |
| | Dielectric constant | 2.5 | - | 8.36 | 8.36 | 40.3 |
| | Dielectric loss tangent | 0.04 | - | 0.43 | 0.43 | 0.42 |
| Reflection layer | Type | CNT sheet | CNT sheet | None | Copper foil | CNT sheet |
| | Thickness (mm) | 0.020 | 0.020 | - | 0.018 | 0.020 |
| | Volume resistivity ($\Omega \cdot$ cm) | $2 \times 10^{-3}$ | $2 \times 10^{-3}$ | - | $2.8 \times 10^{-6}$ | $2 \times 10^{-3}$ |
| Minimum reflection attenuation [60 to 90 GHz] (dB) | | 1 | 3 | 4 | 8 | 2 |
| Maximum reflection attenuation [60 to 90 GHz] (dB) | | 4 | 6 | 7 | 33 | 4 |
| Minimum transmission attenuation [60 to 90 GHz] (dB) | | 50 | 55 | 7 | 84 | 55 |
| Maximum transmission attenuation [60 to 90 GHz] (dB) | | 59 | 62 | 7 | 120 | 61 |
| Reflection attenuation region width of 10 dB or more (GHz) | | 0 | 0 | 0 | 14 | 0 |

Examples in which carbon black was used as the electromagnetic wave absorbing fillers of Examples 1 to 4 show examples using a system containing no optional component (Example 1), a system using alumina as an optional component (Example 2), a system with a dielectric loss tangent of the above formula (1) higher by 20% or more (Example 3), and a system with a film thickness of the above formula (2) thicker by 20% or more (Example 4), respectively. In any example, it can be seen from Table 1 that the reflection attenuation and the transmission attenuation are large in the frequency range of a frequency of 60 GHz to 90 GHz, and the absorption region showing an attenuation of 10 dB or more is also wide. In particular, it can be seen that a high maximum reflection attenuation was obtained in Example 1 and Example 2 in which the dielectric loss tangent and the film thickness were controlled within 20% of the values of the above formulae (1) and (2).

On the other hand, in the case of Comparative Example 1 using no electromagnetic wave absorbing filler, in the case of Comparative Example 2 using only the reflection layer, and in examples of Comparative Example 3 in which the reflection layer is not provided, Comparative Example 4 in which a copper foil having a volume resistivity of $1 \times 10^{-4} \Omega \cdot$ cm or less is used for the reflection layer, and Comparative Example 5 in which the electromagnetic wave absorbing layer has a dielectric constant of more than 30, it can be seen that both of the high reflection attenuation and the high transmission attenuation, and the wide attenuation region width of 10 dB or more are not compatible, and the target performance is not satisfied.

Furthermore, the target performance of the present invention can also be satisfied in Example 5 using carbon fibers as the electromagnetic wave absorbing filler, Examples 6 to 7 using a carbon fiber sheet or a graphite sheet as the reflection layer other than the CNT sheet, and a system using a bismaleimide resin as the binder resin, which are within the scope of the present invention.

As described above, according to the electromagnetic wave shielding member of the present invention, the electromagnetic wave shielding member exhibits a wide absorption band and excellent absorption characteristics and shielding characteristics in a high frequency band of 60 to 90 GHz.

Since the electromagnetic wave shielding member of the present invention has excellent electromagnetic wave shielding characteristics, the electromagnetic wave shielding member can be suitably used for high-speed, large-capacity communication equipment and semiconductor devices used for vehicles.

The present invention is not limited to the above embodiments. The above embodiments are examples, and any form which has substantially the same configuration as the technical idea described in the claims of the present invention and exhibits the same operational effects is included in the technical scope of the present invention.

**Claims**

1. An electromagnetic wave shielding member comprising an electromagnetic wave absorbing layer containing an electromagnetic wave absorbing filler and a binder resin, and a reflection layer disposed on an opposite surface side of an electromagnetic wave incident surface of the electromagnetic wave absorbing layer, wherein the electromagnetic wave absorbing layer has a dielectric constant of 4 to 30 and a dielectric loss tangent of 0.1 to 2.0, the content of the electromagnetic wave absorbing filler is 1 to 20 wt% based on the total weight of the electromagnetic wave absorbing layer, and the reflection layer has a volume resistivity of $1 \times 10^{-4}$ to $1 \times 10^{-1}$ $\Omega \cdot$cm.

2. The electromagnetic wave shielding member according to claim 1, wherein the electromagnetic wave absorbing filler is one or more selected from the group consisting of carbon black, carbon nanotubes, and carbon fibers.

3. The electromagnetic wave shielding member according to claim 1 or 2, wherein the binder resin has a dielectric constant of 5 or less.

4. The electromagnetic wave shielding member according to claim 1 or 2, wherein the reflection layer is made of a carbon material.

5. The electromagnetic wave shielding member according to claim 4, wherein the carbon material is one or more selected from the group consisting of carbon nanotubes, carbon fibers, graphite, and graphene.

6. The electromagnetic wave shielding member according to claim 1 or 2, which has a transmission attenuation of 30 dB or more in an entire frequency band of 60 to 90 GHz.

7. The electromagnetic wave shielding member according to claim 1 or 2, wherein the frequency bandwidth with a reflection attenuation of 10 dB or more is 20 GHz or more in a frequency band of 60 to 90 GHz.

8. The electromagnetic wave shielding member according to claim 1 or 2, which has a reflection attenuation of 20 dB or more in at least a part of a frequency band of 60 to 90 GHz.

# FIG.1

*1*

VERTICALLY INCIDENT
ELECTROMAGNETIC
WAVE

*1a*  *1b*

# EUROPEAN SEARCH REPORT

**Application Number**

EP 25 16 8252

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2003 133784 A (NITTO DENKO CORP) 9 May 2003 (2003-05-09) * paragraph [0023] - paragraphs [0025], [0028] * * examples 1-5 * * claims 1-5 * * figures 2,3,5-8 * | 1-8 | INV. H05K9/00 B32B25/02 C08K3/04 C08K7/06 |
| A | US 2003/044623 A1 (SAKURAI IKUO [JP] ET AL) 6 March 2003 (2003-03-06) * figures 1,2 * * paragraph [0063] * * examples 1-12; tables 1,3 * * claims * | 1-8 | |
| A | JP 2005 286191 A (GELTEC CO LTD) 13 October 2005 (2005-10-13) * example 1 * * claims 1-4 * | 1-8 | |
| A | WO 2024/018995 A1 (MAXELL LTD [JP]) 25 January 2024 (2024-01-25) * examples 1-13 * * claims 1,2 * | 1-8 | TECHNICAL FIELDS SEARCHED (IPC) C08K H05K B32B |
| A | JP 2007 335680 A (SEKISUI PLASTICS; BUSSAN NANOTECH RES INST INC) 27 December 2007 (2007-12-27) * examples 1-4; tables 1,2 * * claims * | 1-8 | |
| A | US 2021/023818 A1 (HAZAMA TAKESHI [JP] ET AL) 28 January 2021 (2021-01-28) * figures 1-6 * * examples 1-5 * * claims * | 1-8 | |

The present search report has been drawn up for all claims

| Place of search | Date of completion of the search | Examiner |
|---|---|---|
| Munich | 6 August 2025 | Russell, Graham |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 25 16 8252

This annex lists the patent family members relating to the patent documents cited in the above-mentioned European search report.
The members are as contained in the European Patent Office EDP file on
The European Patent Office is in no way liable for these particulars which are merely given for the purpose of information.

06-08-2025

| Patent document cited in search report | | Publication date | Patent family member(s) | | Publication date |
|---|---|---|---|---|---|
| JP 2003133784 | A | 09-05-2003 | NONE | | |
| US 2003044623 | A1 | 06-03-2003 | JP | 2002329995 A | 15-11-2002 |
| | | | TW | I300381 B | 01-09-2008 |
| | | | US | 2003044623 A1 | 06-03-2003 |
| JP 2005286191 | A | 13-10-2005 | JP | 4311654 B2 | 12-08-2009 |
| | | | JP | 2005286191 A | 13-10-2005 |
| WO 2024018995 | A1 | 25-01-2024 | JP | WO2024018995 A1 | 25-01-2024 |
| | | | WO | 2024018995 A1 | 25-01-2024 |
| JP 2007335680 | A | 27-12-2007 | NONE | | |
| US 2021023818 | A1 | 28-01-2021 | CN | 111919521 A | 10-11-2020 |
| | | | EP | 3780925 A1 | 17-02-2021 |
| | | | JP | 7286623 B2 | 05-06-2023 |
| | | | JP | 7445159 B2 | 07-03-2024 |
| | | | JP | 2022165989 A | 01-11-2022 |
| | | | JP | WO2019189214 A1 | 15-04-2021 |
| | | | KR | 20200128118 A | 11-11-2020 |
| | | | TW | 201942154 A | 01-11-2019 |
| | | | US | 2021023818 A1 | 28-01-2021 |
| | | | WO | 2019189214 A1 | 03-10-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018168859 A
- JP 2023129145 A
- JP 2020145278 A